# EUROPEAN PATENT SPECIFICATION

(11) **EP 1 760 516 B1**
(45) Date of publication and mention of the grant of the patent: **18.06.2008**
(21) Application number: 06018692.1
(22) Date of filing: 06.09.2006
(51) Int. Cl.: G02F 1/13357, G02F 1/1333, G02F 1/13

(54) **Liquid crystal display device**
Flüssigkristallanzeigevorrichtung
Dispositiv d'affichage à cristaux liquides

(30) Priority: 06.09.2005 JP 2005257868
(43) Date of publication of application: 07.03.2007
(73) Proprietor: Sharp Kabushiki Kaisha, Osaka 545-8522 (JP)
(72) Inventor: Chikazawa, Hideyuki, Tsu-shi Mie 514-0112 (JP); Moriyasu, Mitsuhiro, Suzuka-shi Mie 513-0823 (JP)
(74) Representative: Müller - Hoffmann & Partner

(56) References cited:
- WO-A-01/11421
- JP-A- 2003 140 110
- JP-A- 2005 210 028
- US-A- 3 346 689

## Description

### BACKGROUND OF THE INVENTION

### Field of the Invention

The present invention relates to an electronic device and a liquid crystal display device (hereinafter referred to as "LCD device"), and more particularly, relates to an electronic device and a LCD device suitable for preventing a mistake of a fitting position of a substrate when a plurality of the substrates are fitted in a prescribed base member.

### Description of the Related Art

An electronic device generally comprises a member to be a base (hereinafter referred to as "base member"), such as chassis, in which multiple kinds of substrates (electronic substrates) are fitted. For example, the LCD device (one example of electronic devices) as disclosed in a patent literature 1 (Unexamined Japanese Patent Publication No. 2003-140110) comprises a structure in which a plurality of circuit substrates respectively mounting a LED (Light-Emitting Diode) are aligned and fitted in a case frame to be a base member in a backlight illuminating a liquid crystal display panel (hereinafter referred to as "LCD panel") from its backside.

Here, as shown in Patent literature 1, a LCD device is required to include a backlight for illuminating the entire area of a LCD panel from its backside. However, in regard to a LCD device comprising a large-size LCD panel, a structure is conceivable wherein a plurality of LED substrates for illuminating each division multi-divided from the entire area of the large-size LCD panel from its backside is provided, and the plurality of LED substrates respectively mounting a plurality of LEDs are aligned and fitted in a prescribed base member. Thus, in comparison to the case of manufacturing a piece of large-size LED substrate, the production efficiency (such as cost and yield ratio) is higher since there is no need for a particular production facility for large-size substrates, and also, the handling performance for sipping and assembling becomes better.

In addition, in view of improving production efficiency of LED substrates, it is preferred that all of a plurality of LED substrates is standardized. However, if such standardization is forceful, a part of the LED substrates may be mounted with unnecessary electronic parts, and the structure becomes not always efficient in regard to the entire productivity, including control of the number of parts and improvement of production efficiency of substrates. Consequently, it is sometimes unavoidable to provide different LED substrates according to fitting positions in a base member, and therefore, it is important that each LED is fitted in a designed fitting position and direction (in a qualified fitting position and direction) in a base member.

As mentioned above, many electric devices, such as a LCD device, are comprised of multiple kinds of substrates fitted in a base member. In such electronic devices, each substrate is generally managed by a parts code such as a number or a code that identifies the substrate, and such parts code is often recorded on each substrate by such as serigraph. Additionally, in a conventional assembling process of an electronic device, a worker identifies a kind of a relevant substrate and its fitting position by a parts code recorded on each substrate as referring to such as assembling manuals. In addition, for example, by designing different positions and diameters of threaded holes according to each of the kinds of substrates, a mistake of each substrate being fitted in a wrong position during assembling process can be avoided.

WO 01/11421 discloses a tiled liquid crystal display device wherein the tiles of the display panel are provided with position indication marks.

US 3 346 689 discloses a multilayer circuit board in which a plurality of substrates are placed to be piled. In such a construction as a multilayer substrate a fitting position distinguishing mark would be complicated, and therefore, this is lacking practical use. That document, however, is not related to the specific problems in connection with the illumination of liquid crystal display panels.

Consequently, this invention has been made considering the foregoing conditions, and the purpose of this invention is to provide a liquid display device wherein the entire area of the liquid panel can be uniformly illuminated well, and the fitting position distinguishing mark indicating the designed fitting position of the light-emitting-diode substrate along the base member in said base member can be simply constructed.

### SUMMARY OF THE INVENTION

In order to achieve the above purpose, this invention is to be applied to electronic devices according to the claims.

This enables prevention of mistake of a fitting position of each substrate when a plurality of substrates is fitted in the base member.

In this case, as the fitting position distinguishing mark recorded on each of the substrates, marks such as "upper right comer" and "center" can be conceived, however, a fitting position can be intuitively and accurately identified at a glance when a mark graphically displays an area of relevant substrate within the entire base member that is to be covered by the present substrate when fitted in as designed (correctly). For example, a mark in which a frame indicating the shape of the entire base member is illustrated, and a relevant area within the frame is painted in a prescribed color or pattern.

Also, on each fitting position of the substrate in the base member, it is still more suitable to provide a same or corresponding mark as the fitting position distinguishing mark recorded on the substrate should be fitted in the fitting position.

This enables a worker, who has no particular knowledge of the fitting position distinguishing mark, to identify a fitting position intuitively and accurately by matching marks recorded on the substrate and the base member.

Additionally, on the substrate that has a plurality of candidates for designed fitting positions in the base member, the fitting position distinguishing mark indicating all of those candidates for designed fitting positions may be recorded.

This enables the same fitting position distinguishing marks to be recorded on each of the same kind of substrates when said same kind of substrates is fitted in a plurality of positions (different positions) within the base member. In short, this eliminates the process of manufacturing multiple kinds of substrates merely having different fitting position distinguishing marks though being substantially the same.

In addition, when the fitting position distinguishing mark is recorded in an area that is nearly the same area (the same area or much the same area) within every substrate adjusted in a designed fitting direction relative to the base member, but is other than the center nor in the vicinity thereof in the substrates, a right direction of the substrate can be easily identified by previously knowing the recorded position of the fitting position distinguishing mark. This is suitable for prevention of mistake of a fitting direction of each substrate. For example, on each substrate adjusted in a designed fitting direction relative to the base member, when the fitting position distinguishing mark is recorded in an area of upper left corner of the square-shaped substrate, and if the fitting position distinguishing mark is positioned in the upper right corner, lower right corner, and the lower left corner, it is easily understood that the substrate is misadjusted in the directions 90, 180, and 270-decrees off by one in a clockwise manner relative to the qualified direction.

In other words, a LCD device comprising a plurality of LED substrates which is respectively mounting a plurality of LEDs and illuminating each division multi-divided from the entire area of the LCD panel from the backside of the LCD panel, and a base member in which the plurality of LED substrates are aligned and fitted, wherein a fitting position distinguishing mark that indicates a designed (qualified) fitting position of a relevant LED substrate in the base member is recorded on each of the plurality of LED substrates.

This enables prevention of mistake of a fitting position of each LED substrate, when multiple kinds of LED substrates having similar appearances are fitted in a base member.

According to this invention, it is possible to prevent a mistake of a fitting position of each substrate when a plurality of substrates is fitted in a base member, since a fitting position distinguishing mark indicating a designed (qualified) fitting position of a relevant substrate in the base member is recorded on each of a plurality of the substrates. Additionally, other structures described as capable of being included in said electronic devices in accordance with the present invention can also be applied to said LCD device in accordance with the present invention.

In addition, a fitting position can be intuitively and accurately identified at a glance by a worker when a mark graphically displaying an area in the entire base member which is to be covered by a relevant substrate when fitted in as designed (correctly) is the fitting position distinguishing mark recorded on each of said substrates, and when the same or corresponding mark as the fitting position distinguishing mark recorded on the substrate should be fitted in the fitting position is recorded on each fitting position of the substrate in the base member.

Additionally, on the substrate that has a plurality of candidates for designed fitting positions in the base member, when the fitting position distinguishing mark indicating all of those candidates for designed fitting positions is recorded, the process of manufacturing multiple kinds of substrates which merely have different fitting position distinguishing marks though being substantially the same can be suitably eliminated.

Furthermore, when the fitting position distinguishing mark is recorded in an area that is nearly the same area (the same area or much the same area) within every substrate adjusted in a designed fitting direction relative to the base member, a right direction of the substrate can be easily identified by previously knowing the recorded position of the fitting position distinguishing mark. This is suitable for prevention of mistake of a fitting position of each substrate.

These and other objects, features and advantages of the present invention will become more apparent upon reading of the following detailed description along with the accompanied drawings.

### BRIEF DESCRITPTION OF THE DRAWINGS

Fig. 1 shows a general structure of a backlight unit X in a LCD device according to an embodiment of the present invention;
Fig. 2 shows a first example of a fitting position distinguishing mark recorded on a LED substrate and a chassis that are comprised in Backlight unit X;
Fig. 3 shows a second example of a fitting position distinguishing mark recorded on a LED substrate and a chassis that are comprised in Backlight unit X;
Fig. 4 shows a third example of a fitting position distinguishing mark recorded on a LED substrate that is comprised in Backlight unit X.

### DETAILED DESCRIPTION OF THE PREFERRED EMBODIMENTS

With embodiments of the present invention described hereinafter with reference to the accompanying drawings, it is to be understood that the invention is not limited to those precise embodiments.

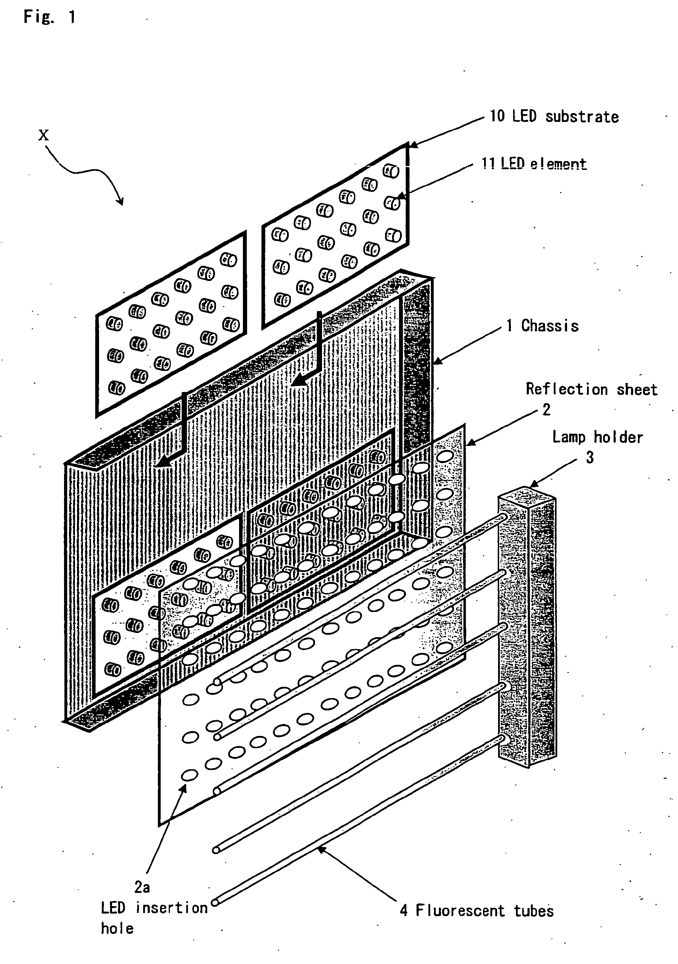

A LCD device according to an embodiment of this invention comprises a backlight unit X as shown in Fig. 1, and Backlight unit X is positioned in the backside of a LCD panel (not shown) illuminating the entire area of the LCD panel from the backside.

As illustrated in Fig. 1, Backlight unit X is formed as extended in width direction across the entire area of a LCD panel, and comprises: a plurality of fluorescent tubes 4 arrayed in vertical direction across nearly the entire area of the LCD panel along a surface that is parallel to the LCD panel, a lamp holder 3 supporting (holding) Fluorescent tubes 4, a plurality of LED substrates 10 respectively mounted with a plurality of LED elements 11 for illuminating each division multi-divided from the entire area of the LCD panel, a chassis 1 as a base member in which the plurality of LED substrates 10 is aligned and fitted, and a reflection sheet 2 reflecting lights of Fluorescent tubes 4 and LED elements 11 to the front side (the side of LCD panel).

Here, in a situation where a plurality of LED substrates 10 is fitted in qualified positions in Chassis 1, each LED element 11 is mounted in a position not interfering with each of Fluorescent tubes 4 seen from the right front (from the side of the LCD panel). Also, LED insertion holes 2a into which each of LED elements 11 are inserted are formed in Reflection sheet 2.

Backlight unit X is a so-called hybrid-type backlight unit illuminating the LCD panel (not shown) by lights of both Fluorescent tubes 4 and LED elements 11 from backside. For example, in order to compensate red light of a prescribed wavelength range which tends to lack in the light of Fluorescent tubes 4 (a compound light of R, G, and B (close to white light)), LED elements 11 emitting red light of said wavelength range is employed as a assistant light source. Other than the above hybrid-type Backlight unit X, a backlight capable of being implemented in accordance with this invention may comprise a plurality of LED substrates, which is respectively mounting a plurality of LED elements emitting each light of R, G, and B, aligned and fitted in Chassis 1, without using Fluorescent tube 4.

Similar to Backlight unit X, the structure including a plurality of LED substrates 10 illuminating each division multi-divided from the entire area of the LCD panel from backside is suitable when conducting backside illumination of a large-size LCD panel such as larger than 60 inches. In other words, compared with employing a piece of large-size LED substrate, the production efficiency (such as cost and yield ratio) is higher since there is no need for a particular production facility for such large-size substrates, and also, the handling performance for sipping and assembling is better.

Additionally, in Fig. 1, two of LED substrates 10 in both vertical and horizontal directions in Chassis 1 are aligned and fitted as an example, however, various embodiments regarding the number of alignment of LED substrates 10 in vertical and horizontal directions are conceivable according to design conditions.

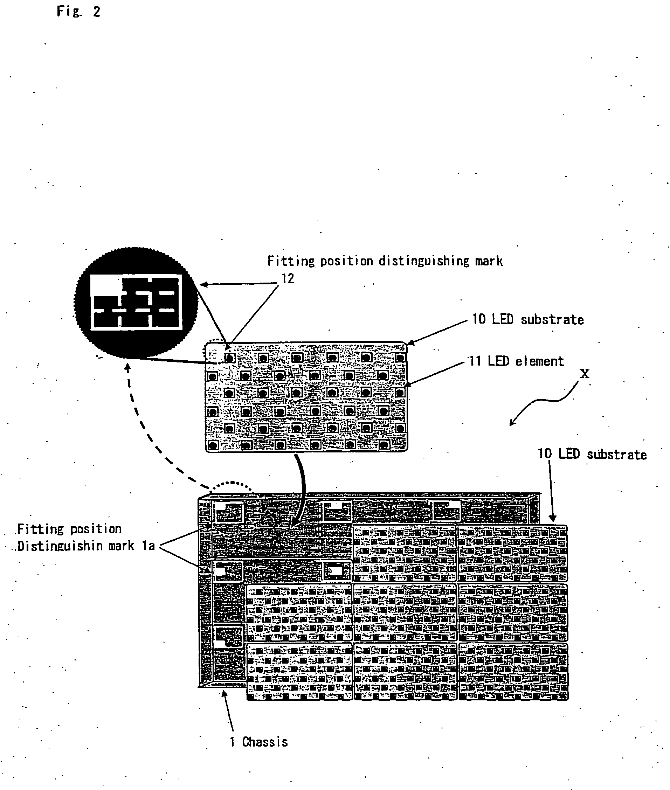

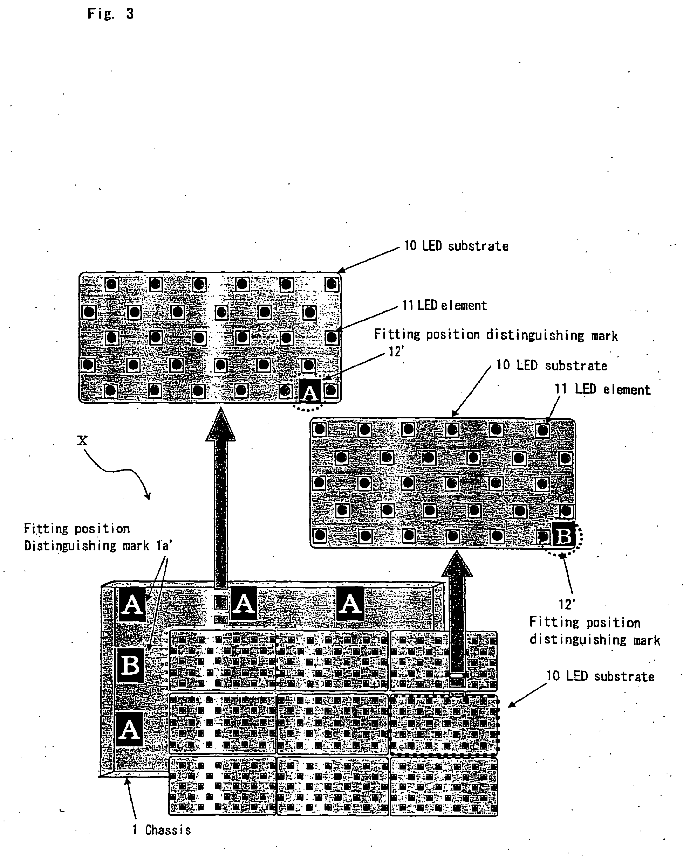

Next, as referring to Figs. 2 and 3, first (Fig. 2) and second (Fig. 3) examples of fitting position distinguishing marks recorded on LED substrate 10 and Chassis 1 as the feature point of Backlight unit X are described.

The feature of Backlight unit X is that fitting position distinguishing marks 12 and 12' indicating designed (qualified) fitting positions of relevant LED substrates 10 in Chassis 1 (base member) are recorded on each of a plurality of LED substrates 10.

Here, the fitting position distinguishing mark 12 shown in Fig. 2 is a mark that graphically displays the area to be covered by a relevant LED substrate 10 in the entire Chassis 1 when the present LED substrate 10 bearing the mark is fitted in Chassis 1 as designed (correctly). In the example illustrated in Fig. 2, Fitting position distinguishing mark 12 shows a frame indicating the shape of the entire Chassis 1, and a relevant area (an area to be covered by LED substrate 10) within the frame is painted in a prescribed color and pattern.

With such Fitting position distinguishing mark 12 recorded on a prescribed position of LED substrate 10 by such as serigraph, a worker can intuitively and accurately identify a fitting position at a glance, and therefore, mistakes of fitting position of each LED substrate 10 can be prevented when a plurality of LED substrates 10 is fitted in Chassis 1.

Furthermore, as shown in Fig. 2, on each fitting position of LED substrate 10 in Chassis 1, marks 1a being the same as Fitting position distinguishing mark 12 recorded on LED substrate 10 should be fitted in the fitting position are recorded.

With the above, a worker with no particular knowledge of Fitting position distinguishing mark 12 can understand a fitting position intuitively and accurately by matching the marks recorded on LED substrate 10 and Chassis 1.

On the other hand, the example illustrated in Fig. 3 indicates that a cord (such as "A" and "B") indicating a designed (qualified) fitting position of each LED substrate 10 in Chassis 1 (base member) is recorded on LED substrate 10 as Fitting position distinguishing mark 12'.

Here, as shown in Fig. 2, on each fitting position of LED substrate 10 in Chassis 1, marks 1a' being the same as Fitting position distinguishing mark 12' (code) recorded on LED substrate 10 should be fitted in the fitting position are recorded, and this enables a worker to understand the correspondence between Fitting position distinguishing mark 12' and the fitting position in Chassis 1.

In addition, in the example shown in Fig. 3, repeated (same) Marks 1a' are recorded in a part of fitting positions of LED substrates 10 in Chassis 1, and this means same Fitting position distinguishing marks 12' are recorded on every LED substrate having same mounted-component. In other words, the example shown in Fig. 3 indicates that Fitting position distinguishing marks 12' indicating all of a plurality of candidates for designed fitting position are recorded on LED substrates 10 having a plurality of candidates for designed fitting position in Chassis 1.

As noted above, by respectively recording the same Fitting position distinguishing mark 12' on the same kind of LED substrates 10 when said same kind of LED substrates 10 are to be fitted in a plurality of positions (different positions) in Chassis 1, a wasting process of manufacturing multiple kinds of LED substrates 10 only having different fitting position distinguishing marks though being substantially the same can be eliminated.

Additionally, in both examples shown in Figs. 2 and 3, on every LED substrate 10 adjusted in a designed fitting direction relative to Chassis 1, Fitting position distinguishing marks 12 and 12' are recorded in the area that is nearly the same but other than the center nor in the vicinity thereof in LED substrate 10 (in Fig. 2, the area near upper left corner, and in Fig. 3, the area near lower right corner).

This is suitable for preventing mistake of a fitting position of each LED substrate 10 since the right direction of LED substrate 10 can be easily identified by previously knowing the recorded position of Fitting position distinguishing marks 12 and 12'.

For example, as shown in Fig. 2, on every LED substrate 10 adjusted in a designed fitting direction relative to Chassis 1, when Fitting position distinguishing mark 12 is recorded in the area of upper left corner of the square-shaped LED substrate 10, and if Fitting position distinguishing mark 12 is positioned in the upper right corner, lower right corner, and the lower left corner, it is easily understood that the present LED substrate 10 is misadjusted in the directions 90, 180, and 270-decrees off by one in a clockwise manner relative to the qualified direction.

Additionally, the same effect can be obtained when the recorded position of Fitting position distinguishing marks 12 and 12' are even in other than the vicinity of corners, for example, in the area near the edge of LED substrates 10 (such as, the central area in horizontal direction in the edge of the upper hem or the lower hem, or the central area in vertical direction in the edge of the left hem or the right hem).

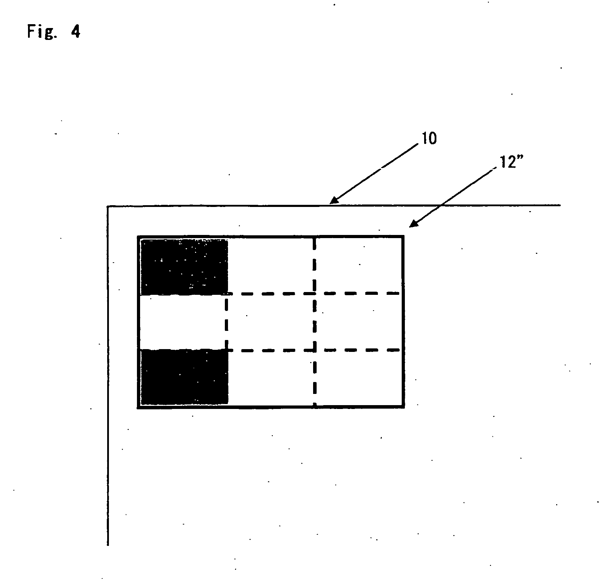

Fig. 4 indicates a case when Fitting point distinguishing mark 12 (the mark graphically displaying the area to be covered by LED substrate 10) shown in Fig.2 is employed, wherein, on LED substrate 10 that has a plurality of candidates for designed fitting positions in Chassis 1, a fitting position distinguishing mark 12" indicating all of said candidates for designed fitting positions is recorded.

In other words, in Fig. 4, Fitting position distinguishing mark 12" is a mark in which a frame indicating the shape of the entire Chassis 1 is illustrated, and all the areas as candidates for fitting positions within the frame are painted in a prescribed color or pattern.

Additionally, the mark recorded in the side of Chassis 1 is the same as Mark 1a illustrated in Fig. 2.

By employing Fitting position distinguishing mark 12" and by recording the same Fitting position distinguishing mark 12" on the same kind of LED substrates 10, in regard to substantially the same LED substrates 10, the wasting process of manufacturing multiple kinds of LED substrates 10 bearing only different fitting position distinguishing marks can be eliminated.

## Claims

1. A liquid crystal display device comprising:
a base member (1);
**characterized in that** the liquid crystal display device further comprises:
a plurality of light-emitting-diode substrates (10) respectively mounting a plurality of light-emitting-diode elements (11) and illuminating each division multi-divided from the entire area of a liquid crystal display panel from backside of said liquid crystal display panel;
a plurality of said light-emitting-diode substrates (10) being aligned and fitted along said base member (1); wherein
fitting position distinguishing marks (12, 12', 12") indicating a designed fitting position of said light-emitting-diode substrates (10) in said base member (1) are recorded on each of said plurality of light-emitting-diode substrates (10).

2. A liquid crystal display device according to Claim 1, wherein said fitting position distinguishing mark recorded on each of said light-emitting-diode substrates is a mark graphically displaying an area to be covered by said light-emitting-diode substrate in entire said base member when said light-emitting-diode substrate is fitted in said base member as designed.

3. A liquid crystal display device according to any of Claims 1 and 2, wherein a mark same as said fitting position distinguishing mark recorded on said light-emitting-diode substrate should be fitted in said fitting position, or a mark corresponding to said fitting position distinguishing mark is recorded on each fitting position of said light-emitting-diode substrate in said base member.

4. A liquid crystal display device according to.any of Claims 1, 2 and 3, wherein said fitting position distinguishing mark indicating all of a plurality of candidates for designed fitting positions is recorded on said light-emitting-diode substrate having said plurality of candidates for designed fitting positions in said base member.

5. A liquid crystal display device according to any of Claims 1, 2, 3 and 4, wherein said fitting position distinguishing mark is recorded in an area that is nearly the same area but other than a center nor vicinity thereof within every said light-emitting-diode substrate adjusted in a designed fitting direction relative to said base member.

## Patentansprüche

1. Flüssigkristallanzeigevorrichtung mit einem Grundelement (1), **dadurch gekennzeichnet, dass** die Flüssigkristallanzeigevorrichtung ferner Folgendes aufweist:
eine Vielzahl von Leuchtdiodensubstraten (10), die jeweils auf Leuchtdiodenelementen (11) angebracht sind und alle Bereiche von der Rückseite eines Flüssigkristallanzeigeschirms beleuchtet, in welche die gesamte Fläche des Flüssigkristallanzeigeschirms unterteilt ist;
wobei eine Vielzahl der Leuchtdiodensubstrate (10) entlang des Grundelements (1) ausgerichtet und eingepasst ist; wobei
Einpasspositions-Unterscheidungsmarkierungen (12, 12', 12"), welche eine vorgesehene Einpassposition der Leuchtdiodensubstrate (10) in dem Grundelement (1) anzeigen, auf jedem der Leuchtdiodensubstrate (10) verzeichnet sind.

2. Flüssigkristallanzeigevorrichtung nach Anspruch 1, wobei die auf jedem der Leuchtdiodensubstrate verzeichnete Einpasspositions-Unterscheidungsmarkierung eine Markierung ist, die grafisch einen Bereich anzeigt, welcher von dem Leuchtdiodensubstrat vollständig zu bedecken ist, wenn das Leuchtdiodensubstrat in das Grundelement wie vorgesehen eingepasst wird.

3. Flüssigkristallanzeigevorrichtung nach Anspruch 1 oder 2, wobei eine Markierung wie die auf dem Leuchtdiodensubstrat verzeichnete Einpasspositions-Unterscheidungsmarkierung in die Einpassposition eingepasst werden soll, oder eine Markierung entsprechend der Einpasspositions-Unterscheidungsmarkierung auf jeder Einpassposition des Leuchtdiodensubstrats in dem Grundelement verzeichnet ist.

4. Flüssigkristallanzeigevorrichtung nach einem der Ansprüche 1 bis 3, wobei die alle in Frage kommenden vorgesehenen Einpasspositionen anzeigende Einpasspositions-Unterscheidungsmarkierung auf dem Leuchtdiodensubstrat verzeichnet ist, welches die in Frage kommenden vorgesehenen Einpasspositionen in dem Grundelement aufweist.

5. Flüssigkristallanzeigevorrichtung nach einem der Ansprüche 1 bis 4, wobei die Einpasspositions-Unterscheidungsmarkierung in jedem der in einer ausgelegten Einpassrichtung relativ zu dem Grundelement gerichteten Leuchtdiodensubstrate in annähernd dem gleichen Bereich verzeichnet ist, wobei dieser Bereich nicht eine Mitte eines Leuchtdiodensubstrats oder deren direkte Nachbarschaft ist.

## Revendications

1. Dispositif d'affichage à cristaux liquides comprenant:
un élément formant base (1) ;
**caractérisé en ce que** le dispositif d'affichage à cristaux liquides comprend en outre :
plusieurs substrats de diode électroluminescente (10) supportant respectivement plusieurs éléments de diode électroluminescente (11) et éclairant, par l'arrière d'un panneau d'affichage à cristaux liquides, chaque division issue de la multi-division de toute la surface dudit panneau d'affichage à cristaux liquides ;
plusieurs desdits substrats de diode électroluminescente (10) étant alignés et montés le long dudit élément de base (1) ; dans lequel
des marques de repérage de position de montage (12, 12', 12") indiquant une position de montage prévue desdits substrats de diode électroluminescente (10) dans ledit élément formant base (1) sont inscrites sur chacun desdits substrats de diode électroluminescente (10).

2. Dispositif d'affichage à cristaux liquides selon la revendication 1, dans lequel ladite marque de repérage de position de montage inscrite sur chacun desdits substrats de diode électroluminescente (10) est une marque affichant graphiquement une zone devant être couverte par ledit substrat de diode électroluminescente dans l'ensemble dudit élément formant base lorsque ledit substrat de diode électroluminescente est monté comme prévu dans ledit élément formant base.

3. Dispositif d'affichage à cristaux liquides selon l'une quelconque des revendications 1 et 2, dans lequel une marque identique à ladite marque de repérage de position de montage inscrite sur ledit substrat de diode électroluminescente devant être monté dans ladite position de montage, ou une marque correspondant à ladite marque de repérage de position de montage, est inscrite sur chaque position de montage dudit substrat de diode électroluminescente dans ledit élément formant base.

4. Dispositif d'affichage à cristaux liquides selon l'une quelconque des revendications 1, 2 et 3, dans lequel ladite marque de repérage de position de montage indiquant tous les candidats parmi plusieurs candidats pour des positions de montage prévues est inscrite sur ledit substrat de diode électroluminescente comportant lesdits candidats pour des positions de montage prévues dans ledit élément formant base.

5. Dispositif d'affichage à cristaux liquides selon l'une quelconque des revendications 1, 2, 3 et 4, dans lequel ladite marque de repérage de position de montage est inscrite dans une zone qui est pratiquement la même zone mais autre qu'un centre ou son voisinage à l'intérieur de chaque substrat de diode électroluminescente ajusté dans une direction de montage prévue relativement audit élément formant base.
